# EUROPÄISCHE PATENTANMELDUNG

(11) **EP 1 566 470 A2**
(43) Veröffentlichungstag der Anmeldung: **24.08.2005**
(21) Anmeldenummer: 05003903.1
(22) Anmeldetag: 23.02.2005
(51) Int. Cl.: C30B 29/12, C30B 33/00, G02B 5/30

(54) **Herstellung von grossvolumigen CaF2-Einkristallen für die Verwendung als optische Bauelemente mit einer optischen Achse parallel zur (100) oder (110)-Kristallachse**

(30) Priorität: 23.02.2004 DE 102004008752
(71) Anmelder: Schott AG, 55122 Mainz (DE)
(72) Erfinder: Parthier, Lutz, Dr., 14532 Kleinmachnow (DE); Stäblein, Jörg, 07743 Jena (DE)
(74) Vertreter: Fuchs Mehler Weiss & Fritzsche

(57) **Zusammenfassung**

Es wird ein Verfahren zur Herstellung von hochhomogenen, spannungsarmen Einkristallen, insbesonders aus Calciumfluorid beschrieben. Die Einkristalle weisen auch in von (111)-abweichenden Richtungen, insbesondere in den (100) und (110)-Richtungen eine ausgezeichnete optische Qualität auf. Das Verfahren umfasst einen Temperschritt, in dem der Kristall mit Temperaturraten von weniger als 18 K/h auf eine Temperatur von 1000 - 1350°C erwärmt und mindestens 65 Stunden lang auf dieser Temperatur gehalten wird, wobei im Kristall maximal ein Temperaturunterschied von 0,2 K vorliegt. Anschließend wird der Kristall derart abgekühlt, dass in einem Temperaturbereich oberhalb einer Grenztemperatur zwischen 900°C und 600°C die Abkühlgeschwindigkeit maximal 0,5 K/h, und unterhalb dieses Bereiches die Abkühlgeschwindigkeit maximal 3 K/h beträgt. Mit diesem Verfahren werden Kristalle erhalten, die sowohl in (111)-Richtung, (100)-Richtung als auch (110)-Richtung eine Brechzahlhomogenität von < 0,025 x 10⁻⁶ (RMS-Wert) aufweisen. In (111)-Richtung weist der Kristall eine Spannungsdoppelbrechung von < 0,5 nm/cm (PV) und 0,15 nm/cm (RMS) auf und in (100)-Richtung und/oder (110)-Richtung eine Spannungsdoppelbrechung von < 2,5 nm/cm (PV) und < 1 nm/cm (RMS) auf.

## Beschreibung

Die Erfindung betrifft ein Verfahren zur Herstellung von optischen Bauelementen aus Calciumfluorid mit parallel (100) oder (110) orientierter optischer Achse (Hauptrichtung) durch Temperung bei erhöhter Temperatur und entsprechend angepaßter Abkühlung, sowie deren Verwendung.

CaF₂ wird als Material für optische Bauelemente für VUV-Anwendungen in der Mikrolithographie wie Waferstepper oder Excimerlaser eingesetzt. Die Kristalle bilden das Ausgangsmaterial für die Herstellung von Linsen, Prismen und anderen Bauteilen, die wiederum in Optiken zur Abbildung kleinster Strukturen zur Herstellung integrierter Schaltungen z.B. für Computerchips verwendet werden. Um die notwendige Abbildungsgüte zu erreichen, werden an das optische Material sehr hohe Anforderungen gestellt. Üblicherweise darf die Inhomogenität der Brechzahl Δn nicht mehr als 1 x 10⁻⁶ betragen, die Spannungsdoppelbrechung muß deutlich unter lnm/cm liegen.

Die Verknüpfung zwischen mechanischen Größen (wie z.B. Spannungen) und der durch sie verursachten optischen Wirkung (wie z. B. die Spannungsdoppelbrechung SDB) ist im Kristall (richtungsabhängig) über den spannungsoptischen Tensor gegeben. Das bedeutet, Spannungen gleicher Größe können in einem einkristallinen Material in Abhängigkeit von der kristallographischen Orientierung bzw. der Beobachtungsrichtung zu deutlich unterschiedlicher Spannungsdoppelbrechung und Brechzahlhomogenität führen. Aus diesem Grunde wurden bisher Bauelemente eingesetzt, bei denen die minimale Spannungsdoppelbrechung in der Anwendungsrichtung zu beobachten ist. Das ist für Calciumfluorid in der (111)-Richtung der Fall. Bisher wurde daher Material ausschließlich in der Orientierung (111) für Rohlinge (bzw. (111)-nahe für Kuben) eingesetzt.

Die Untersuchungen von J.H. Burnett, Z.H. Levine, E.L. Shirley, "Intrinsic birefringence in calcium fluoride and barium fluoride", Physical Rev. B 64 (2001) 241102 haben gezeigt, dass das Calciumfluorid intrinsisch doppelbrechend wirkt. Dieser Effekt nimmt in der Nähe der Bandkante des Materials stark zu und führt bei einer Anwendungswellenlänge von 157nm zu deutlichen Abbildungsfehlern. Um diese intrinsische Doppelbrechung kompensieren zu können, werden von den Objektivherstellern Linsen unterschiedlicher Kristallorientierung kombiniert. Daraus ergibt sich die Notwendigkeit, Linsenrohlinge, Quader und Prismen verschiedener Kristallorientierung, speziell in (100)- und (110)-Orientierung, zu fertigen.

Die Anforderungen an die nicht-(111)-orientierten Produkte bezüglich der optischen Qualität, speziell der Brechzahlhomogenität und Spannungsdoppelbrechung sind vergleichbar mit den Anforderungen, die an das (111)-Material gestellt werden. Allerdings sind diese Anforderungen an die Qualität für nicht-(111)-orientierte Produkte ungleich schwerer erreichbar. Die Restspannungen im Material müssen für (100) bzw. (110)-orientierte Produkte um 80 bis 90% geringer sein als für (111)-orientierte Produkte, wenn die gleiche Spannungsdoppelbrechung erreicht werden soll.

Die Möglichkeiten zur Herstellung von Einkristallen zur Verwendung als optische Bauelemente sind bekannt und die Prinzipien sind in Lehrbüchern wie z. B. Wilke-Bohm, Kristallzüchtung (Verlag Harri Deutsch, ISBN 3-87144-971-7) beschrieben. Je nach Stoffsystem und Anforderungen können Einkristalle aus der Gasphase, der Schmelze, Lösungen oder einer Festphase über Diffusions- bzw. Rekristallisationsprozesse nach unterschiedlichsten Verfahren hergestellt werden.

Die Herstellung geeigneter CaF₂-Halbzeuge bzw. Rohlinge erfolgt in einem mehrstufigen Prozeß. Zunächst ist die Voraussetzung, dass als Rohstoff ein CaF₂-Pulver zur Verfügung steht, welches höchsten Anforderungen an die chemische Reinheit genügt. Spuren kritischer Kationen und/oder Anionen dürfen nur im sub-ppm Bereich bzw. für weniger kritische Verunreinigungen bis zu einigen ppm enthalten sein. Dieses Pulver wird dann üblicherweise im Vakuum einer Trocknungsphase unterzogen, um vorhandene Restfeuchte zu entfernen. Störender Restsauerstoff wird dem CaF₂ mittels einem beigemengten zweiten Material, durch ein nachfolgendes Erhitzen über eine sogenannte Scavenger-Reaktion entzögen. Scavenger-Substanzen sind z. B. ZnF₂, PbF₂ oder andere geeignete Fluoride oder aber fluorhaltige Gase.

Die üblichen Verfahren zur Herstellung von Calciumfluorideinkristallen im industriellen Maßstab sind zum Beispiel das Bridgman-Stockbarger-, das Vertical Gradient Freeze-, das Nakken-Kyropoulos- und das Czochralski-Verfahren. Diese Verfahren sind allesamt Zuchtverfahren aus der Schmelze, die im Vakuum bzw. unter einer Inert- oder Reaktivgasatmosphäre verlaufen. Dabei wird jeweils das polykristalline Material in einem Tiegel aufgeschmolzen. Anschließend läßt man die Schmelze sehr langsam gerichtet erstarren, um Einkristalle entstehen zu lassen. Die folgende Abkühlung muß derart erfolgen, dass möglichst geringe thermische Spannungen im Kristall auftreten, die Kristalldefekte hervorrufen.

Zur Erfüllung der hohen Anforderungen für die VUV-Anwendungen ist es notwendig, die Kristalle oder Teile davon einer weiteren Temperaturbehandlung unterhalb des Schmelzpunktes zu unterziehen, um die Kristalldefekte zu reduzieren und die geringe Spannungsdoppelbrechung sowie hohe Brechzahlhomogenität zu erreichen. Während dieses als Tempern bezeichneten Prozesses werden bei der erhöhten Temperatur im Kristall durch mechanische Deformations- und Diffusionsprozesse die noch vorhandenen Defekte wie Versetzungen oder Kleinwinkelkorngrenzen deutlich abgebaut. Die dann folgende Abkühlphase bestimmt ganz wesentlich das erzielte Qualitätsniveau des Bauteils. Das Tempern kann als Prozeßschritt unmittelbar in der Kristallzuchtanlage oder aber auch als separater Prozess in einem speziellen Ofen ausgeführt werden.

Einige typische Vorgehensweisen beim Tempern von Calciumfluorid wurden bereits in der EP 0 939 147 A2 oder in der US 6,332,922 B1 beschrieben. Dabei werden insbesondere die Temperatur-Zeit-Bedingungen beschrieben, um Calciumfluoridkristalle bezüglich ihrer Spannungsdoppelbrechung und Brechzahlhomogenität zu verbessern. Die beschriebenen Verfahren führen jedoch nicht zu Kristallen, die die erforderliche Qualität für die inzwischen aktuellen Anforderungen der Mikrolithographie bei Anwendungswellenlängen von 193 nm bzw. 157 nm erreichen.

In EP 0 942 297 A2 wird beschrieben, dass aufgrund der Anisotropie des spannungsoptischen Verhaltens für Lithographieanwendungen die (111)-Orientierung von Rohlingen bzw. Halbzeugen zu bevorzugen ist. Dabei wurden die (111), (100), (110)-Orientierungen untersucht und es wurde gefunden, dass bei gleichartiger Wärmebehandlung von CaF₂-Scheiben unterschiedlicher Orientierung nur die (111)-Scheibe Spannungsdoppelbrechungswerte nahezu im geforderten Bereich erreicht. Am Beispiel von BaF₂-Scheiben wird gezeigt, dass auch die erreichte Reduzierung der SDB durch die Wärmebehandlung für die (111)-Scheibe wesentlich größer ist, als die für nicht (111)-orientierte Scheiben.

Wie CaF₂ mit von (111) verschiedener optischer Hauptrichtung in der geforderten Qualität produziert werden kann, ist bislang nicht bekannt.

Die Erfindung hat daher zum Ziel, durch Temperung bei erhöhter Temperatur in einem geeigneten Ofen CaF₂-Kristalle in einer optischen Qualität herzustellen, die für den Einsatz mit einer von der (111)-Kristallachse verschiedenen optischen Hauptrichtung, speziell entlang der (100) bzw. (110)-Achse, in der Mikrolithographie insbesonders bei Wellenlängen von unterhalb 250 nm, speziell bei 193 nm oder kürzer erforderlich ist.

Ein wesentliches Ziel der Erfindung ist es auch, durch Verformungs- und Ausheilprozesse im Kristall bei erhöhten Temperaturen die im Kristallmaterial vorliegenden Restspannungen und Inhomogenitäten zu minimieren, um so einen defektarmen Kristall mit geringsten Restspannungen zu erhalten, dessen Spannungsdoppelbrechung in keiner Richtung höher als 1 nm/cm beträgt und dessen Brechzahlinhomogenität Δn in jeder Richtung kleiner als 5*10⁻⁷ beträgt.

Ein weiteres wesentliches Ziel der Erfindung besteht darin, nicht nur eine Verringerung der Transmission für Licht der Wellenlängen von unterhalb 250 nm bzw. von 193 nm oder kürzer im Vergleich zum ungetemperten Rohmaterial zu verhindern, sondern im Gegenteil sogar eine Verbesserung durch die Temperaturbehandlung (Tempern) zu erreichen. Dazu ist es notwendig, die Ausprägung von Absorptions- und Streuzentren während der Temperaturbehandlung zu verhindern.

Ebenfalls Ziel der Erfindung ist der Abbau vorhandener und die Vermeidung der Entstehung von neuen, sogenannten Gleitbändern. Gleitbänder sind typischerweise Kristalldefekte, die durch inhomogene plastische Verformung entlang der materialtypischen Verformungsebenen und -richtungen entstehen und die im Verhältnis zu ihrer Umgebung lokal eine sehr hohe Versetzungsdichte aufweisen und zu optischen Inhomogenitäten und Spannungsdoppelbrechung im Material führen.

Diese Ziele werden durch das in den Ansprüchen beschriebene Verfahren erreicht.

Es hat sich gezeigt, dass sich die Kristalldefekte im CaF₂ hinreichend weit reduzieren lassen, um die genannten Ziele zu erreichen, wenn der Kristall auf Temperaturen von über 1000°C erwärmt wird und bei der eingestellten Temperatur wenigstens 65 Stunden, vorzugsweise mindestens 75 Stunden gehalten wird, wobei mindestens 80 Stunden besonders bevorzugt sind. Erfindungsgemäß wurde gefunden, dass entgegen bisherigen Vorstellungen diese gegenüber bisher bekannten Prozessen deutlich verlängerte Zeit erforderlich ist, um die notwendigen Relaxationsvorgänge im Kristall ablaufen zu lassen. Die einzustellende Haltetemperatur beträgt erfindungsgemäß mindestens 1000°C, vorzugsweise mindestens 1050°C, wobei mindestens 1080°C bzw. 1100°C besonders bevorzugt sind. Zweckmäßige Obergrenzen betragen erfindungsgemäß maximal 1350°C, insbesonders 1300°C, wobei eine maximale Temperatur von 1250°C bzw. 1200°C bevorzugt ist. Erfindungsgemäß hat es sich auch als vorteilhaft erwiesen, dass während der Haltezeit möglichst keine oder nur minimale Temperaturunterschiede im Kristall auftreten, d. h. dass die Temperatur über das gesamte Kristallvolumen hinweg möglichst gleich bzw. homogen ist.

Die extremen Anforderungen an die Spannungsfreiheit der Kristalle werden insbesonders dann erfüllt, wenn neben der Reduzierung der dynamischen Temperaturgradienten durch Heiz- und Kühlprozesse auch die statischen Temperaturgradienten in der Anlage verringert werden. Statische Temperaturgradienten werden durch die räumliche Temperaturverteilung (Ofendesign) im Temperofen verursacht. Sie treten auch in der Haltezeit auf. Dynamische Temperaturgradienten treten im Tempergut auf, wenn von außen (Ofen) Wärme zu- oder abgeführt wird. Ein Wärmetransport bedingt Temperaturgradienten im Material und die Größe dieser Gradienten wird wesentlich von den Aufheiz- und Abkühlgeschwindigkeiten bestimmt. Diese Gradienten werden hier als dynamische Temperaturgradienten bezeichnet. In Aufheiz- und Abkühlphasen überlagern sich beide Arten von Gradienten.

Nach dem Aufheizen, d. h. während der Haltezeit bei Haltetemperatur bilden sich im Temperraum statische Temperaturgradienten in radialer und statische Temperaturgradienten in axialer Richtung heraus. Durch die Ofenkonfiguration werden gemäß der vorliegenden Erfindung diese auf maximal 0,2 K/cm begrenzt. Vorzugsweise werden jedoch statische, radiale Temperaturgradienten von kleiner als 0,013 K/cm und statische, axiale Temperaturgradienten von kleiner als 0,07 K/cm gewährleistet.

Vorzugsweise lässt man den Ausheilprozess in einer Anlage ablaufen, die in dem Bereich, in dem sich das zu tempernde Material befindet, ein Temperaturfeld mit einem Temperaturgradienten von maximal 0,2K/cm erzeugt.

Die Anlage sollte vorzugsweise in ihrem Inneren ausschließlich aus hochreinem Graphit bestehen, um Kontaminationen der CaF₂-Kristalle auszuschließen, welche zu einer Minderung der Transmission führen können. Ein bevorzugtes Graphit, welches in Kontakt mit dem CaF₂ kommt weist einen Restaschegehalt von weniger als 20 ppm auf.

Die Anforderungen an die Reinheit bestehen ebenso an die zu tempernden Produkte. Vor Beschickung der Anlage sind daher die Teile einer sorgfältigen Reinigung zu unterziehen. Die Teile sollen sowohl fett- und staubfrei sein, sowie möglichst keine Oberflächenfeuchte ausweisen. Bevorzugt wird daher eine Reinigung der Teile mit fettlösenden organischen Lösungsmitteln mit hohem Dampfdruck. Nach erfolgter Reinigung ist jede Berührung der Teile mit bloßer Haut oder verschmutzten Gegenständen zu vermeiden.

Zur Entfernung des in der Anlage, an der Kristalloberfläche bzw. im Kristallgitter vorhandenen Restsauerstoffs wird vorzugsweise wenigstens ein Scavenger-Material eingesetzt. Als vorteilhaft erweisen sich Verbindungen wie ZnF₂, PbF₂, XeF₂, SnF₂, welche als Feststoffe zugesetzt werden. Es ist auch möglich, nach einer ausgeprägten Trockenphase gasförmige Scavenger einzusetzen. Hierbei sind besonders Fluorgas, Fluorgas/Inertgasmischungen, Fluorkohlenstoffgase bzw. Fluorkohlenwasserstoffgase vorteilhaft zu verwenden. Eine Kombination von fest- und gasförmigen Scavengern kann auch verwendet werden.

In einer bevorzugten Ausführungsform wird die Temperung unter Einsatz von gasförmigem Scavenger vorgenommen, beispielsweise CF₄, C₂F₆, C₃F₈ oder CHF₃, SF₆ oder NF₃ bevorzugt unter dem Einsatz von Fluorkohlenstoffgasen, welche mit Inertgas vermischt in einer Konzentration von 1-50%, insbesondere 5-30%, speziell 5-15% in die Anlage eingebracht wird. Durch den Einsatz eines solchen Gases gelingt es überraschenderweise die Transmission des CaF₂ zu erhöhen. Dieser Effekt wird nicht bei Einsatz von Inertgas, Vakuum oder pulverförmigen Scavengermaterial erreicht.

In besonderer Weise bevorzugt wird eine Ausführung wie zuvor beschrieben, bei der während des Temperprozesses ein Gasgemisch mit der zuvor angegebenen Zusammensetzung mit einem Durchfluss von wenigen Litern pro Minute durch die Anlage strömen läßt.

Bei besonderer Sorgfalt bezüglich der Reinheit und Sauerstofffreiheit aller in der Anlagen befindlichen Materialien und Oberflächen kann auf ein Scavengermaterial verzichtet werden. Dabei ist zunächst eine Trocknung im Hochvakuum auszuführen, um adsorbiertes Oberflächenwasser und Sauerstoff vollständig zu entfernen. Die Temperung kann im Vakuum, aber auch in einer Inertgasatmosphäre stattfinden.

Die Anforderungen an die Reinheiten der festen Scavenger-Materialien sind im wesentlichen die gleichen wie für CaF₂. Wird beispielsweise PbF₂ als Scavenger verwendet sind bei den Elementen Na, Mg, Sr, Ba, Al und den Übergangsmetallen Reinheitsanforderungen von <lppm je Element einzuhalten.

Zur Vermeidung von Kontaminationen, welche letztlich zur Verringerung der Transmission führen können, hat es sich gezeigt, dass die eingesetzten Gase vorzugsweise eine Reinheit von mindestens 99,999% , bevorzugt besser 99,9999% aufweisen sollten.

Die Temperung wird vorteilhafterweise unabhängig von zugesetzten Materialien und dem bestehenden Druck in der Anlage - unter einer reduzierenden Atmosphäre ausgeführt.

In einer speziellen Ausführungsform wird in das Tempergefäß zusätzlich CaF₂-Pulver eingebracht. In einer weiteren erfindungsgemäßen Ausführungsform wird daher derart vorgegangen, dass ein Kristall gegenüber seinem finalen Endmaß in einem größeren Volumen bzw. mit einem größeren Aufmaß getempert wird und nach dem Tempern dieses Aufmaß entfernt wird. Das Tempern selbst erfolgt üblicherweise in einem hierfür geeigneten Ofen bzw. einer Anlage. Dabei wird vorzugsweise so viel Randvolumen abgetragen, dass der Kristall bereits in einem endnahen Maß vorliegt. Vorzugsweise wird das Material vom Kristallmittelpunkt aus bezüglich seiner Höhe und/oder seines Durchmessers entlang des Umfangs bzw. äußeren Randes zirkumferential entfernt. In einer bevorzugten Ausführungsform beträgt das Aufmaß mindestens 5%, vorzugsweise mindestens 10% des Endmaßes bzw. der endmaßnahen Dimension, wobei ein Aufmaß bzw. Übermaß von +15%, insbesondere +20%, bevorzugt ist. Als besonders bevorzugt haben sich Aufmaße von +25 bzw. +30% erwiesen. Dabei beziehen sich die Aufmaße vorzugsweise auf den Durchmesser bzw. die Höhe des Kristalls. Soll beispielsweise das Endmaß bzw. die endmaßnahe Dimension des Kristalls 20 cm aufweisen, so wird der Kristall bei einem 20%-igen Aufmaß mit einem Durchmesser von mindestens 24 cm getempert. Ein späteres Tempern nach Entfernung des Randes, der die innere elastische Restspannung im Kristall verursacht, sollte nicht mehr stattfinden.

Es hat sich überraschenderweise gezeigt, dass sich mittels diesem Verfahren orientierte Blanks erhalten lassen, die bezüglich des RMS-Wertes der Brechzahlhomogenität besser als 0,025 x 10⁻⁶, insbesonders besser als 0,015 x 10⁻⁶ sind. Bezüglich der Spannungsdoppelbrechung lassen sich Werte erhalten, wie sie in folgende Tabelle eingetragen sind:

**Tabelle 1**

| | <111>-Orientierung | | <100> bzw. <110>-Orientierung | |
|---|---|---|---|---|
| | vorzugsweise | besonders bevorzugt | vorzugsweise | besonders bevorzugt |
| SDB - PV-Wert in nm/cm | 0,5 | 0,2 | 2,5 | 1 |
| SDB - RMS-Wert in nm/cm | 0,15 | 0,08 | 1 | 0,35 |

Das erfindungsgemäße Verfahren eignet sich zur Herstellung von Kristallen aller Formen und aller Orientierungen. So ist es beispielsweise ohne weiteres möglich, auch Kristalle anstatt in (111)-Richtung in (100)-, oder (110)-Orientierung annähernd spannungsfrei zu erhalten, was mit den bisherigen Verfahren des Standes der Technik nicht möglich war.

In einer erfindungsgemäß bevorzugten Ausführungsform wird beim Tempern ein geringer Temperaturgradient erzeugt, der in einem Winkel von mindestens 5° von der Gleitebene abweicht.

Die Richtung des maximalen Temperaturgradienten ist gleichzeitig die Richtung der höchsten Spannungen. Da der Kristall sich nur entlang bestimmter Gleitrichtungen auf bestimmten Gleitebenen plastisch verformt, ist für die Verformung nur die in diesem Gleitsystem wirksame Spannung für die Verformung relevant.

Im Falle des CaF₂ ist die Hauptgleitebene die (100)-Ebene. Treten die maximalen Temperaturgradienten parallel bzw. senkrecht zur Oberfläche einer 100-Scheibe auf, sind die Spannungen im Gleitsystem voll wirksam. Erfindungsgemäß wurde gefunden, dass, durch Verkippen der Scheibenorientierung die wirksamen Spannungen reduziert werden. Im Falle der 111-Orientierung (Der Winkel zwischen 111-Oberfläche und 100-Gleitebene beträgt 54,73°) ist diese wirksame Spannungskomponente deutlich reduziert. Der beste denkbare Fall wäre in diesem Sinne eine (110)-Orientierung. In diesem Falle aber würde das zweite (Neben-) gleitsystem mit 110 als Gleitebene extrem günstig orientiert sein und aktiviert werden.

Es ist erfindungsgemäß bevorzugt, dass zwischen Gleitrichtung und Richtung des maximalen Temperaturgradienten ein Winkel von 10° eingeschlossen wird. Besonders bevorzugt sind für den CaF2-Kristall sowie für Kristalle gleicher Struktur Winkel von 25° bis 36°.

In anderen Kristallsystemen können auch größere Winkel erreicht werden. Gemäß der Lehre der Erfindung, wird jedoch in Kristallsystem der maximal mögliche Winkel zwischen Gleitrichtung und Richtung des Temperaturgradienten einzustellen.

Besonders bevorzugt wird der Kristall in seiner (111)-Richtung getempert und zwar so, dass diese (111)-Achse parallel zur Achse des verwendeten Temperofens verläuft. Dabei ist es bevorzugt, dass der im Temperofen erzeugte Temperaturgradient parallel zur Erdoberfläche verläuft, bzw. senkrecht zur Erdanziehung.

Die räumliche Temperaturverteilung im gesamten Kristallvolumen ergibt sich aus der Überlagerung statischer Temperaturgradienten (anlagenbedingte Temperaturverteilung) mit den dynamischen Temperaturgradienten, welche infolge von Aufheiz- bzw. Abkühlvorgängen im Kristall entstehen. Erstere dominieren die Haltezeit, letztere kommen vor allem in der Aufheiz- und Abkühlphase zum tragen.

Für das erfindungsgemäße Tempern ist es unvermeidbar, dass die von außen auf den Kristall zugeführte Wärme beim Aufwärmen des Kristalls einen geringen, jedoch keinen zu großen Temperaturgradienten erzeugt. Dieser Gradient sollte derart ausgestaltet sein, dass während des Erwärmens, sowie während des Abkühlens an keiner Stelle des Kristalles ein Temperaturunterschied von mehr als 5°C herrscht. Vorzugsweise beträgt die Obergrenze der Temperaturunterschiede maximal 2°C, wobei maximal 1°C besonders bevorzugt ist. Es ist auch bevorzugt, dass diese maximalen Temperaturunterschiede nicht in einem inneren Volumenbereich des Kristalls auftreten; d. h. in einem Bereich, der mindestens 10% des Kristalldurchmessers vom Kristallrand entfernt ist. Obwohl es nicht bevorzugt ist, können im Randbereich geringfügige höhere Temperaturunterschiede herrschen, als die zuvor angegebenen.

Die extremen Anforderungen an die Spannungsfreiheit der Kristalle werden insbesonders dann erfüllt, wenn die dynamischen Temperaturgradienten während der Aufheizphase und was noch wesentlich bedeutungsvoller ist, während der Abkühlphase so reduziert werden, dass sie gleich oder nur unwesentlich größer als die statischen Temperaturgradienten während der Haltezeit bei Maximaltemperatur sind.
Vorzugsweise lässt man den Ausheilprozess in einer Anlage ablaufen, die in dem Bereich, in dem sich das zu tempernde Material befindet, einen statischen radialen Temperaturgradienten von kleiner als 0,013 K/cm und einen axialen Temperaturgradienten von kleiner als 0,07K/cm gewährleistet.

Erfindungsgemäß ist es bevorzugt, den Kristall beim Tempern mittels einer Graphitauflage abzudecken. Bevorzugt sind Graphitmatten oder Graphitplatten. Graphitplatten tragen zur Verringerung des Temperaturgradienten im Tempergut bei, indem eine gleichmäßige Wärmezu- und -abfuhr in bzw. aus dem Kristall befördert wird. Die Graphitabdeckungen haben eine gute Wärmeleitfähigkeit. Obwohl es erfindungsgemäß bevorzugt ist, das Tempern mittels einer im Ofen seitlich angeordneten Heizung durchzuführen und dabei die Wärmezufuhr und den somit entstehenden Gradienten seitlich, d. h. parallel zur Erdoberfläche auf den Kristall einwirken zu lassen, so ist es auch möglich dies mittels einer Deckel- und Bodenheizung durchzuführen; dabei hat es sich als zweckmäßig erwiesen, besonders gut wärmeleitende Graphitplatten auf den Kristall zu legen.

Ein weiterer Aspekt der vorliegenden Erfindung ist es, den besonderen Materialeigenschaften, die sich bei Anwendungsrichtungen, die von der [111] abweichen ergeben, in der Prozeßführung bei der Temperung Rechnung zu tragen. Es hat sich gezeigt, dass es zum Erreichen geringer Spannungsdoppelbrechung in diesen Richtungen notwendig ist, nicht nur in der Haltezeit sondern auch während der Aufheiz- und Abkühlphase des Temperprozesses die Temperaturgradienten wesentlich kleiner zu gestalten, als in bisher für Calciumfluorid bekannten Temperprozessen. vorzugsweise sind erfindungsgemäß beim Aufheizen Raten von weniger als 18K/h einzustellen, vorzugsweise weniger als 12K/h, wobei Aufheizraten von weniger als 10K/h besonders bevorzugt sind. Erfindungsgemäß wurde auch gefunden, dass geringe Aufheizraten wesentlich sind, um ein gutes Temperendergebnis zu erreichen. Es hat sich nämlich gezeigt, dass auch während des Aufheizens generierte Defekte im Falle von nicht (111)-orientierten Blanks sich einerseits wesentlich störender auf das Endergebnis auswirken und andererseits wesentlich schwerer (während der Haltezeit) relaxieren.

Gemäß der vorliegenden Erfindung sind beim Abkühlen sehr geringe Abkühlraten einzuhalten, die in einem oberen Temperaturbereich besonders klein und in einem unteren Temperaturbereich etwas größer sein können, was Zeit und Kosten spart. Die Übergangstemperatur, bei der von der sehr geringen Abkühlrate auf eine geringe Abkühlrate übergegangen wird, liegt in dem Temperaturbereich zwischen 900°C und 600°C. Die Übergangstemperatur liegt dabei um so tiefer, je höher die Qualitätsanforderungen an das Produkt sind.

Gemäß der vorliegenden Erfindung sind beim Abkühlen im oberen Temperaturbereich Abkühlraten einzuhalten, die weniger als 0,5 K/h, vorzugsweise weniger als 0,4 K/h, und insbesondere weniger als 0,3 K/h betragen.

Im unteren Temperaturbereich sind Abkühlraten einzuhalten, die nicht über 3 K/h, bevorzugt nicht über 2 K/h, insbesondere nicht über 1,7 K/h betragen.

Unterhalb dieses Temperaturbereiches von 900°C - 600°C können die Abkühlraten zur Minimierung der Prozeßzeit und der damit verbundenen Kosten erhöht werden. Die Erhöhung der Abkühlrate kann in einem Schritt, bevorzugt aber in mehreren Schritten erfolgen. Die Temperaturraten im unteren Temperaturbereich dürfen gemäß dieser Erfindung nicht über 3 K/h, bevorzugt nicht über 2 K/h, insbesondere nicht über 1,7 K/h erhöht werden.

Der Übergang zwischen dem oberen und unteren Temperaturbereich der Abkühlphase, in welchem die Abkühlrate schrittweise erhöht werden kann, liegt in dem Temperaturbereich zwischen 900°C und 600°C. Die Übergangstemperatur liegt dabei umso tiefer, je höher die Qualitätsanforderungen an das Produkt sind.

Das erfindungsgemäße Verfahren eignet sich zur Herstellung von Kristallen aller Formen und aller Orientierungen. So ist es beispielsweise ohne weiteres möglich, auch Kristalle anstatt in (111)-Richtung in (100)-, oder (110)-Orientierung annähernd spannungsfrei zu erhalten, was mit den bisherigen Verfahren des Standes der Technik nicht möglich war.

Die Erfindung betrifft auch die Verwendung der so erhaltenen Kristalle für optische Zwecke, insbesonders als Rohling bzw. Halbzeuge für optische Elemente. Eine bevorzugte Anwendung der so erhaltenen Kristalle betrifft die Mikrolithographie, üblicherweise die Mikrolithographie < 250 nm, insbesonders bei 248 nm bzw. bei 193 nm und vorzugsweise bei 157 nm. Die erfindungsgemäß erhältlichen optischen Elemente sind insbesonders Prismen und Linsen, die in optischen Anordnungen, insbesonders Objektiven verwendet werden. Werden diese in der Mikrolitho- und Photographie eingesetzt, dann sind damit Stepper, Excimer-Laser, Wafer, Computerchips herstellbar, sowie integrierte Schaltungen und elektronische Geräte, die solche Schaltungen und Chips enthalten.

Die Erfindung soll durch das folgende Beispiel näher erläutert werden.

### Beispiel:

Ein mittels dem Bridgman-Stockbarger-Verfahren hergestellter Einkristall mit einem Durchmesser von 250mm und einer Höhe von 60mm wird in ein Graphitgefäß eingesetzt. Als Scavenger-Material wird PbF2-Pulver zugegeben. Durch eine zwölfstündige Trockenphase wird die Restfeuchte aus dem Prozessraum entfernt. Anschließend wird der Anlage ein Ar/CF₄-Gemisch zugeführt bis zu einem Druck von 1050mbar. Der Druck wird bei einem Durchfluss von 10l/h über den gesamten Prozess konstant geregelt. Der Kristall wird mit 20K/h auf eine Temperatur von 1130°C aufgeheizt. Diese Temperatur wird für 80h beibehalten. Danach wird die Abkühlung nach folgendem Temperaturregime ausgeführt: Abkühlung auf 900°C mit -0,3K/h, Abkühlung auf 650°C mit -0,6K/h, Abkühlung auf Raumtemperatur mit -1,8K/h. Eine nach diesem Vorgehen hergestellte Kristallscheibe hatte in (100)-Richtung eine Spannungsdoppelbrechung von unter 0,9nm/cm(PV-Wert) und 0,31nm/cm(RMS-Wert). Der RMS-Wert der Brechzahlhomogenität lag bei 0,014 x 10⁻⁶. Die Transmission bei einer Wellenlänge von 157nm verbesserte sich um 5%.

## Patentansprüche

1. Verfahren zur Herstellung von hochhomogenen, spannungsarmen Einkristallen, insbesonders aus Calciumfluorid, insbesonders für optische Anwendungen, deren optische Qualität auch in von (111)-abweichenden Richtungen, insbesondere den (100) und (110)-Richtungen, das einen Temperschritt umfasst, **dadurch gekennzeichnet, dass** man zum Tempern den Kristall mit Temperaturraten von weniger als 18 K/h auf eine Temperatur von 1000 - 1350°C erwärmt, der Kristall mindestens 65 Stunden lang auf dieser Temperatur gehalten wird, wobei im Kristall maximal ein Temperaturunterschied von 0,2 K vorliegt und anschließend der Kristall derart abgekühlt wird, dass in einem Temperaturbereich oberhalb einer Grenztemperatur zwischen 900°C und 600°C die Abkühlgeschwindigkeit maximal 0,5 K/h, und unterhalb dieses Bereiches die Abkühlgeschwindigkeit maximal 3 K/h beträgt.

2. Verfahren nach Anspruch 1 **dadurch gekennzeichnet, dass** das Aufheizen mit einer Geschwindigkeit von weniger als 10 K/h erfolgt.

3. Verfahren nach einem der vorhergehenden Ansprüche, **dadurch gekennzeichnet, dass** das Tempern in einer Anlage erfolgt, in der eine reduzierende Atmosphäre herrscht.

4. Verfahren nach einem der vorhergehenden Ansprüche **dadurch gekennzeichnet, dass** das Tempern im Beisein von PbF₂, ZnF₂, XeF₂ als Feststoff erfolgt.

5. Verfahren nach einem der vorhergehenden Ansprüche, **dadurch gekennzeichnet, dass** der maximale Temperaturunterschied im Kristall beim Abkühlen oberhalb einer Grenztemperatur zwischen 900°C und 600°C weniger als 0,3 K beträgt.

6. Verfahren nach einem der vorhergehenden Ansprüche, **dadurch gekennzeichnet, dass** die Temperung der Kristalle als zylindrische Körper erfolgt, unabhängig von der Geometrie des späteren Produkts.

7. Ein Verfahren zur Herstellung hochtransparenter CaF₂-Einkristalle nach Anspruch 1 bis 6 **dadurch gekennzeichnet, dass** zur Entfernung von Restfeuchte in der Anlage zunächst ein Vakuum von mindestens 10⁻⁴ mbar angelegt wird, das Tempern selbst unter einem Druck im Tempergefäß von 10-1050 mbar durchgeführt wird.

8. Homogener CaF₂-Kristall mit verbesserter Transmission, erhältlich nach dem Verfahren nach einer der Ansprüche 1 bis 7 **dadurch gekennzeichnet, dass** der Kristall in 111-Richtung, 100-Richtung und/oder 110-Richtung eine Brechzahlhomogenität von < 0,025 x 10⁻⁶ (RMS-Wert) aufweist und/oder dass der Kristall in 111-Richtung eine Spannungsdoppelbrechung von < 0,5 nm/cm (PV) und 0,15 nm/cm (RMS) aufweist und in 100-Richtung und/oder 110-Richtung eine Spannungsdoppelbrechung von < 2,5 nm/cm (PV) und < 1 nm/cm (RMS) aufweist.

9. CaF₂-Kristall nach Anspruch 8, **dadurch gekennzeichnet, dass** er in 111-, 110-, und/oder 100-Richtung eine Brechwerthomogenität von < 0,015 x 10⁻⁶ (RMS-Wert) und/oder in 111-Richtung eine Spannungsdoppelbrechung von < 0,2 nm/cm(PV) und/oder < 0,08 nm/cm(RMS) und/oder in 110- und/oder 100-Richtung eine Spannungsdoppelbrechung von < 1 nm/cm(PV) und/oder < 0, 35 nm/cm(RMS) aufweist.

10. Verwendung von nach dem Verfahren der Ansprüche 1-7 erhaltenen Einkristallen sowie Kristall nach Anspruch 8 zur Herstellung von Linsen, Prismen, Lichtleitstäben und optischen Komponenten für die DUV-Fotolithographie, deren optische Achse bzw. Hauptausbreitungsrichtung des Lichtes nicht die (111)-Richtung des Kristalls ist, Steppern, Excimerlasern, Wafern, Computerchips, sowie integrierten Schaltungen und elektronischen Geräten, die solche Schaltungen und Chips enthalten.
